# EUROPEAN PATENT APPLICATION

(11) **EP 3 285 325 A1**
(43) Date of publication of application: **21.02.2018**
(21) Application number: 16184977.3
(22) Date of filing: 19.08.2016
(51) Int. Cl.: H01M 10/48, G01R 31/36, H02H 9/04, G01R 19/165, H01M 6/50

(54) **INDICATOR AND METHOD FOR PROVING AN OCCURRENCE OF A CRITICAL VOLTAGE**

(71) Applicant: ROBERT BOSCH GMBH, 70442 Stuttgart (DE); Lithium Energy and Power GmbH & Co. KG, 70469 Stuttgart (DE)
(72) Inventor: Riedmann, Matthias, 70188 Stuttgart (DE); Kohn, Peter, 70178 Stuttgart (DE); Hafenbrak, Robert, 70469 Stuttgart (DE); Greiner, Daniel Bernd, 72070 Tuebingen (DE); Wagner, Christian, 70469 Stuttgart (DE)

(57) **Abstract**

The invention relates to an indicator (10) for proving an occurrence of a critical voltage in a device (1), in particular a battery module, comprising a first electrode (13) connected to a first terminal (14.1),
and a second electrode (17) connected to a second terminal (14.2) for establishing an electrical connection (14) to the device (1),
and a reservoir (11) housing an electrolyte (12), wherein at least the first electrode (13) is at least partly immersed in the electrolyte (12). Furthermore the invention relates to a method (200) for proving an occurrence of a critical voltage of a device (1).

## Description

The invention relates to an indicator for proving an occurrence of a critical voltage according to claim 1 and a method for proving an occurrence of a critical voltage according to claim 6.

### State of the art

Electrical devices, such as batteries or electric motors, usually are designed for a range of voltage, wherein the voltage does not cause a failure of the respective electrical device. Therefore, manufacturers of electrical devices or components thereof often provide a specific voltage range that can comprise a safety and guarantee their device or component to function as long as the voltage does not leave the specific voltage range. That is one reason why it sometimes can be interesting or even necessary to prove whether the voltage has left the specific voltage range during the device's or component's lifecycle. For example in manufacturing batteries or fuel cells sometimes the manufacture of cells has an interest in keeping the voltage low to ensure a long life of the cells, wherein simultaneously the manufacturer of the battery or fuel cell itself has an interest to use a high voltage with the cell to gain as much power as possible. In case of a failure of the cells the proof, whether the voltage had left the specific voltage range or not, can be important for the guarantee.

It is known from the state of the art that electrical devices or components thereof can comprise an electronic surveillance of the used voltage to prove the occurrence of an overvoltage or an undervoltage. However, such an electronic surveillance can be manipulated and sometimes fail for example due to software reasons.

From DE 10 2012 103 702 A1 a device for proving an overvoltage is known. It is for example proposed to use a gas-filled conductor which has a barrier effect until a voltage threshold is exceeded. In case of an overvoltage the gas-filled conductor changes irreversibly for providing a proof of the overvoltage. Thereby, the circuitry, the gas-filled conductor is arranged in, is complex. Furthermore, the conductor only provides the information, if an overvoltage had occurred without displaying quantitative information. Additionally, after proving an overvoltage once, the conductor cannot be used again.

### Disclosure of the invention

Further features and details of the invention result from the dependent claims, the description and the drawings. Thereby, the features and details which are described corresponding to the indicator according to the invention naturally also apply corresponding to the method according to the invention and vice versa, so that according to the disclosure of the single aspects of the invention, it can always be reciprocally related to.

An indicator according to the present invention for proving an occurrence of a critical voltage in a device, in particular a battery module, comprises a first electrode connected to a first terminal and a second electrode connected to a second terminal for establishing an electrical connection to the device. Further, the indicator comprises a reservoir which houses an electrolyte, wherein the first electrode is at least partly immersed in the electrolyte. The electrolyte and the first electrode are configured in such a way that a chemical reaction between the electrolyte and the first electrode is caused, when a voltage of the electrical connection differs from a predefined voltage range.

In particular, an indicator is provided that can reliably show whether a critical voltage has occurred and has a safety against manipulation, preferably while being able to be manufactured at reasonable production costs.

Preferably, the second electrode can also be at least partly immersed in the electrolyte. However, the second electrode can alternatively be at least partly immersed in an additional electrolyte, in particular wherein the electrolyte and the additional electrolyte can be separated by a membrane preferably being permeable for cations. Therefore, the first and the second electrode can enable to establish an electrical connection to the device, in particular while only causing a current, when the voltage of the electrical connection differs from the predefined voltage range.

In particular, when the voltage of the electrical connection falls below a first voltage threshold and/or exceeds a second voltage threshold, the chemical reaction is caused. The voltage threshold can be at least one value defining the predefined voltage range, particularly wherein the values within the predefined voltage range are assumed to be not of interest or not critical to the function of the device. The indicator can be an element or a component which is able to be connected to or within a circuitry for providing the proof of the occurrence of the critical voltage. The critical voltage can be a voltage or a voltage range that is higher and/or lower than the predefined voltage range. So the critical voltage can be an overvoltage and/or an undervoltage. Further, a critical voltage can be understood as a voltage that can cause a failure or malfunction of the device or that is of interest in another way. In particular, the indicator can also be used to prove the occurrence of a voltage to achieve an overview about the operating conditions of the device in the field.

Preferably, the electrolyte is a solid or a fluid, in particular a liquid or a gas, which is able to produce an electrically conductive solution. The electrolyte can for example comprise a salt, particularly a lithium salt. Further, the first electrode can serve as a conductor for electrons in correspondence with the second electrode and the electrolyte, particularly when the chemical reaction is in progress. In particular, the second electrode can also react with the electrolyte when the voltage of the electrical connection differs from the predefined voltage range. Therefore, the first electrode preferably can comprise copper and/or the second electrode can comprise carbon. The reservoir can be a housing or a case being able to contain the electrolyte. Preferably, therefore the reservoir can comprise a seal to keep the electrolyte inside and thus increase the reliability of the indicator. The indicator can be used for any device to prove the occurrence of an overvoltage and/or an undervoltage as long as the predefined voltage range of the indicator fits to the overvoltage and/or undervoltage to be detected. However, preferably the device is a device being able to provide electrical power or a component of such an apparatus, for example a battery cell, battery module, a battery, or a fuel cell. The terminals can be points or portions, where it is possible to electrically connect the indicator to the device or at least to respective interfaces of the device. So, preferably, the electrical connection can be established between the first and the second terminal and the device, in particular wherein the first terminal can serve as a positive pole and the second terminal can serve as a negative pole and/or the first terminal can serve as a negative pole and the second terminal can serve as a positive pole.

As a result the indicator provides a chemical reaction between at least one electrode and the electrolyte. In particular, the chemical reaction can be an electrochemical reaction. Therefore, preferably a current can be enabled or caused between the first and the second electrode, when the voltage of the electrical connection differs from the predefined voltage range. This causes a change of the electrode and/or the electrolyte which becomes recognizable afterwards. The change can for example be a change in shape of at least one of the electrodes, a change in the color of the electrolyte or a change of another visible or at least detectable characteristic of the indicator.

It is further conceivable that the chemical reaction can be reversible. In particular, when the voltage of the device returns to the predefined voltage range a reverse reaction can be caused. However, such a reverse reaction can be chaotic so that the shape of the electrode is not completely recovered as it was manufactured before. So, a memory effect of the occurrence of critical voltages is provided and the occurrence of the critical voltage can still be detected, though a reverse reaction can be enabled. Under a reversible reaction can be understood that at least a part of the effect that results from the reaction can be inverted, so that the original condition, e.g. shape of electrodes, is at least partly recovered. For example parts of the electrode which had dissolved before, can become solid at the electrode again. Therefore, the indicator can be reused again while still maintaining the possibility to read out the condition of the members of the reaction to provide the proof of the occurrence of the critical voltage.

Preferably, at least one electrode of the indicator according to the invention can be electrically connected to at least a first resistor, in particular so as to affect the voltage and/or the predefined voltage range. The first resistor can preferably be arranged between the first or the second electrode and the first and/or second terminal so as to be connected in series. By implementing a resistor, the voltage of the device can be a different voltage than the voltage applied to the electrodes of the indicator, wherein a relation between the voltage of the device and the electrodes can be maintained. Thus, it is not necessary that the predefined voltage range equals an operating voltage range of the device. Instead, the first resistor can adjust the voltage applied to the indicator by the device so that the predefined voltage range defining the range within which the chemical reaction is not caused, stays in a, in particular linear, relation to the voltage of the device. It is furthermore conceivable that a second resistor can be electrically connected to at least one electrode. In particular the second resistor can be arranged in parallel to the first and/or the second electrode. In particular, in case the in particular inherent resistance of the indicator is not known precisely, the implementation of the second resistor can be an advantage. Preferably, the arrangement of at least two resistors, at least one being connected in parallel and at least one being connected in series can therefore serve as a voltage divider. Thereby, the first and the second resistor can preferably be connected in series to each other.

It is further conceivable that the first electrode of the indicator has a first portion comprising a first electrode material and a second portion comprising a second electrode material, wherein the first portion at least partly covers the second portion. In particular, the second electrode material can be more corrosive or less corrosive to the electrolyte than the first electrode material. Advantageously, the second portion can be arranged as a core of the first portion, wherein the second portion is preferably directly connected to the terminal and/or the resistor, for example by wire. Thus, the visibility of the result of the chemical reaction is improved, in particular as a possible reverse reaction can mix up the materials becoming solid again. It is further conceivable that the second portion is partly covered by the first portion and partly covered by a third portion or further portions. The third portion or further portions can provide another material with a different corrosiveness or another material that is not reactive to the electrolyte at all. To be more corrosive, the second electrode material can advantageously be less noble than the first electrode material. So, the first material can comprise Lithium-Gold, Lithium-Platine, or copper graphite, while the second material can include a material such as iron or copper, for example. Further, the first and the second portion can be partly, preferably completely, immersed in the electrolyte. Hence, the accuracy and reliability of the proof of the occurrence of the critical voltage can be improved as the first portion can dissolve in the electrolyte prior to the second portion. Then, the time and/or level of the critical voltage can be estimated by the amount the second and/or first portion has dissolved. Furthermore, the safety against manipulation is increased, in particular since returning to the original shape of the electrode becomes more complicated. Additionally, providing at least a first and a second portion is an easy way of improving proof of the critical voltage. In case the first portion completely dissolves in the electrolyte and the second portion is highly reactive, the reaction can even continue after the voltage returns to the predefined voltage range to provide the proof of an overvoltage or undervoltage.

It is further conceivable for an indicator of the present invention that a diode is arranged between the first electrode and the first terminal and/or between the second electrode and the second terminal. Providing a diode is an easy, not expensive way of preventing the reverse reaction, in particular even if the chemical reaction itself is reversible. Preferably, the diode can be a semiconductor diode. As the diode only allows one direction of current, the reverse reaction can be suppressed after returning to the predefined voltage range. Thus, the proof of the occurrence of the critical voltage is kept. As the diode is not expensive, the costs of the indicator can be kept low.

The invention further includes a power source, in particular a battery cell, a battery module, a battery or a fuel cell, being connected in parallel to an indicator according to the invention. Advantageously, two indicators can be connected in parallel to the power source, wherein the first indicator is designed to prove an occurrence of undervoltage and the second indicator is designed to prove an occurrence of overvoltage.

Another aspect of the present invention is a method for proving an occurrence of a critical voltage of a device, in particular a battery module, comprising the following steps:
a) Connecting at least a first and/or second terminal of an indicator, in particular according to any one of the claims 1 to 5, to the device and applying a voltage to the indicator,
b) Processing of a chemical reaction between a first electrode connected to the first terminal and an electrolyte housed in a reservoir of the indicator, when a voltage of the electrical connection differs from a predefined voltage range, wherein a result of the chemical reaction becomes recognizable.

Here, under recognizable can be understood a visible or perceptible or another kind of verification or at least a hint that the chemical reaction was processed or has been processed. Therefore, it is conceivable that the method includes a further step:
c) Comparing a condition of the indicator to a reference condition for proving the occurrence of the critical voltage.

Thus, the reference condition can be the original condition, the electrode had comprised, when it was installed in the reservoir. This reference condition, for example, can be based on a drawing or on characteristic data as the diameter of the electrode after manufacturing. Therefore, the method according to the invention can provide all the advantages as discussed in the context of the indicator according to the invention.

In particular, a method is provided that can reliably show whether a critical voltage has occurred and has a safety against manipulation, preferably while being able to be executed at reasonable costs.

Advantageously, the chemical reaction can include at least partly a dissolving of a first electrode material of the first electrode for entering a solution with the electrolyte. Hence, a simple proof of the occurrence of the critical voltage is provided as the shape of the electrode can change during dissolving. In case the chemical reaction is reversible, the reverse reaction can be chaotic and therefore the shape of the electrode, after the chemical reaction is processed at least once, differs from the reference condition.

It is further conceivable that the chemical reaction can include a dissolving of at least a part of a second electrode material of a second electrode portion of the first electrode in the electrolyte, in particular after the complete or essentially complete dissolving of the first electrode material of the first electrode portion. Advantageously, the second electrode material can be at least partly covered by the first electrode material. Hence, the second electrode material can keep dissolving after the voltage returns to the predefined voltage range, in particular so that a reverse reaction, in particular of the first electrode material, is prevented. Therefore, an easy way which provides high safety against manipulation is provided.

Advantageously, the chemical reaction can include an accumulation of at least a part of the electrolyte by the first electrode. This can cause a change in shape and/or color of the electrode and/or the electrolyte to provide the proof of the occurrence of the critical voltage.

It is also conceivable that the method further comprises the following step:
d) Preventing a reverse reaction by at least one diode which is connected in series with the first electrode and the first terminal and/or the second electrode, in particular which is at least partly immersed in the electrolyte (12), and the second terminal (14.2).

This can improve the proof of the occurrence of the critical voltage as a reverse reaction is suppressed. Furthermore, the safety against manipulation is improved. In particular, the occurrence of the critical voltage can be quantified as every time, the voltage falls below and/or exceeds a voltage threshold, the reaction continues. Thus, the state of the indicator, in particular the shape of at least one electrode, represents an accumulation of all reactions during the operation.

The steps of the method can be preferably executed in the alphabetical order, in particular a) to b), a) to c) or a) to d), or in a different order. Further, single or all steps of the method can be repeated, in particular.

Further advantages, features and details of the invention result from the following description, in which with reference to the drawings embodiments of the invention are described in detail. Thereby, the features described in the claims and in the description can be each single or in every combination be essential for the invention. It is shown in:
- Fig. 1: an indicator according to the present invention in a schematic illustration in a first embodiment,
- Fig. 2a+b: an indicator according to the present invention in a schematic illustration in a second embodiment,
- Fig. 3: an indicator according to the present invention in a schematic illustration in a third embodiment,
- Fig. 4: a diagram of a voltage characteristic in a further embodiment,
- Fig. 5: a flow chart of a method according to the present invention in a further embodiment,
- Fig. 6: a flow chart of a method according to the present invention in a further embodiment.

In the different figures same features always correspond to the same reference signs, therefore generally the features are only described once.

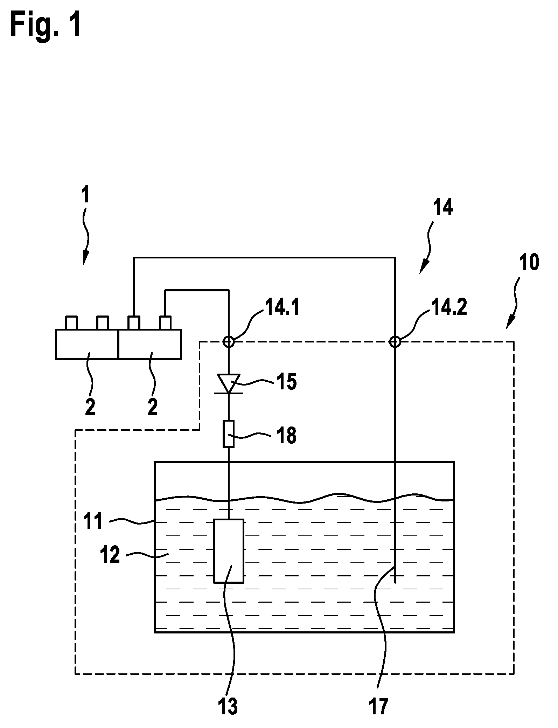

Figure 1 shows an indicator 10 according to the present invention in a schematic drawing in a first embodiment. The indicator 10 comprises a reservoir 11 housing an electrolyte 12. Here, the electrolyte 12 is a fluid. Therefore, the indicator 10 is easy to assemble as the electrolyte 12 can be filled into the reservoir 11 at least essentially independent of other components of the indicator 10. However, it is also conceivable that the electrolyte 12 can be a solid. Further, a first electrode 13 and a second electrode 17 are at least partly immersed in the electrolyte 12 and therefore also at least partly housed in the reservoir 12. While the first electrode 13 is connected to a first terminal 14.1, the second electrode 17 is connected to a second terminal 14.2 providing means for an electrical connection 14 to a device 1. Thus, the first and the second terminal 14.1, 14.2 can be connected to the device 1. When a critical voltage applies to the indicator 10 by the device 1 or occurs in another way in the indicator 10, a chemical reaction 203 at least of the first electrode 13 and the electrolyte 12 processes and thus changes at least one characteristic of the first electrode 13 and/or the electrolyte 12 so as to provide a proof of the occurrence of the critical voltage. Preferably, then a current between the first and the second electrode 13, 17 can be caused. Additionally, a first resistor 18 and a diode 15 can be connected in series to the first electrode 13. Here, it is also conceivable that the first resistor 18 and/or the diode 15 are arranged in connection with the second electrode 17, in particular instead of the first electrode 13. By using the first resistor 18, a voltage 103 of the device 1 and/or a predefined voltage range 100 of the indicator 10 can be adjusted. As the voltage 103 can represent the actual voltage of an operation of the device 1, the predefined voltage range 100 can be a range, wherein the voltage 103 is assumed to be not of interest, for example as it can not cause any failure in the device 1. By using the diode 15, a reverse reaction of the first electrode 13 can be prevented. However, the diode 15 and/or the first resistor 18 is optional to the indicator 10. Preferably, the indicator 10 can be connected by the first and the second terminal 14.1, 14.2 to the device 1. Advantageously, the device 1 can be a battery, a battery module, or a fuel cells comprising cells 2 for providing a power source. However, the device 1 can also be a single battery cell 2, preferably so that each battery cell 2 of a battery can be connected to an indicator 10 as shown. It is furthermore conceivable that a second resistor can be connected in parallel to the first and the second terminal 14.1, 14.2 establishing the electrical connection 14, and in particular in series to the first resistor 18. In this case a voltage divider can be created, in particular so that it is not necessary to know the inherent resistance of the indicator 10 for dimensioning precisely. Furthermore, it can be an advantage, when the first resistor 18 and/or the second resistor comprise a high impedance to limit a discharge current and particularly make the indicator 10 therefore sensitive to low currents.

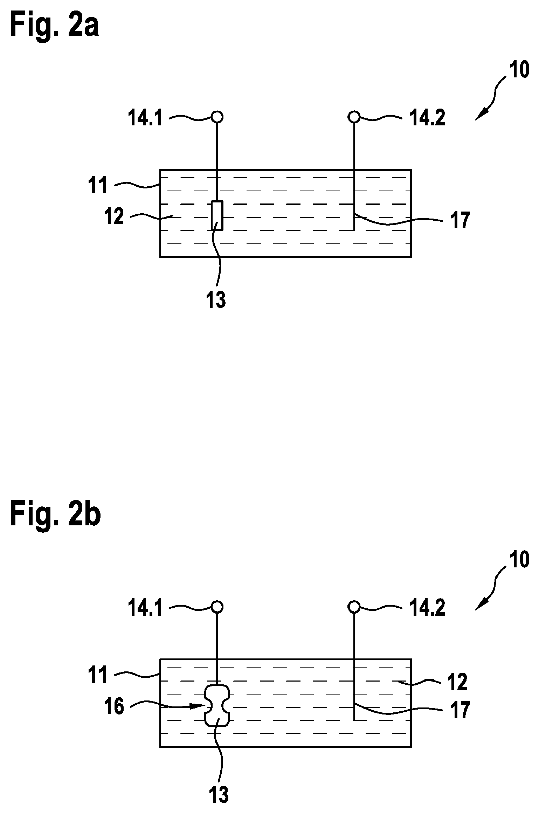

Fig. 2a shows an indicator 10 according to the present invention in a schematic drawing of a second embodiment prior to any occurrence of a critical voltage. As shown in the first embodiment of the indicator 10, the indicator 10 comprises a reservoir 11 housing an electrolyte 12 into which a first electrode 13 and a second electrode 17 are at least partly immersed. Each electrode 13, 17 is connected to a terminal 14.1, 14.2 for being able to be connected to a device 1. However, in case that a voltage which is applied to the terminal 14.1, 14.2 becomes a critical voltage and thus differs from a predefined voltage range 100, a chemical reaction 203 is processed, wherein the first electrode 13 is dissolved at least partly in the electrolyte 12. Here, the chemical reaction 203 is reversible and therefore a reverse reaction processes after the voltage 103 at the terminal 14.1, 14.2 returns to the predefined voltage range 100. Consequently, the state of the indicator 10 after the occurrence of the critical voltage and therefore after the chemical reaction 203 as well as after the following reverse reaction is shown schematically in figure 2b. Here, the reverse reaction was processed chaotically and hence, the shape of the first electrode 13 has changed in comparison to the shape of the first electrode 13 of figure 2a prior to the occurrence of the critical voltage. This change of shape can for example be materialized in an irregularity 16 in the shape of the first electrode 13. The irregularity 16 can preferably be a necking of the first electrode 13. As a result, the occurrence of the critical voltage can be proven by comparing the condition of the first electrode 13 after the chemical reaction 203 to the condition before, in particular wherein the condition before represents the reference condition.

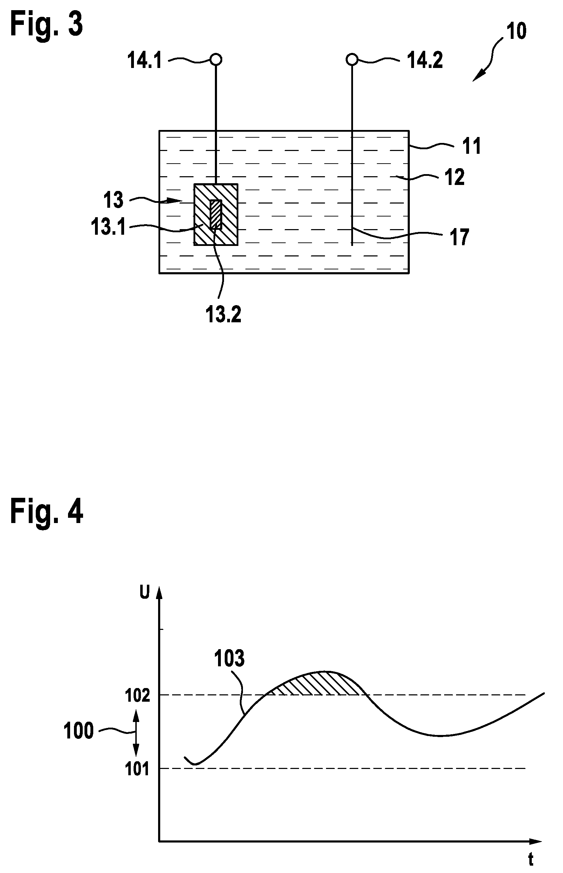

In figure 3 a third embodiment of an indicator 10 according to the present invention is shown. As shown in the first and the second embodiment, the indicator 10 of the third embodiment comprises an electrolyte 12 which is housed in a reservoir 11, wherein a first electrode 13 and a second electrode 17 are at least partly immersed in the electrolyte 12. Furthermore, each of the first electrode 13 and the second electrode 17 are connected to a terminal 14.1, 14.2 for being able to establish an electrical connection 14 between the indicator 10 and a device 1. However, the first electrode 13 comprises a first electrode portion 13.1 and a second electrode portion 13.2. Here, the second electrode portion 13.2 is arranged as a core portion of the first electrode portion 13.1 and thus at least essentially completely covered by the latter. In particular, the first electrode portion 13.1 can comprise a first electrode material and the second electrode portion 13.2 can comprise a second electrode material. Preferably, the first electrode material can be less corrosive than the second electrode material. Therefore, the process of the chemical reaction 203 is divided into parts, wherein the first part includes a dissolving of at least a part of the first electrode portion 13.1. In case the critical voltage is not high enough and/or occurs not for a respective time a reverse reaction will be processed after returning to a predefined voltage range 100 by the electrolyte 12 and the first electrode portion 13.1, wherein the first electrode portion 13.1 can end up with a shape that differs from the original shape of the first electrode portion 13.1. However, the chemical reaction 203 can further provide a second part, wherein the first electrode 13.1 is completely dissolved and consequently uncovers the second electrode portion 13.2. Hence a reverse reaction can be chaotic and mix up the first electrode material and the second electrode material or the reverse reaction can be prevented by the second electrode portion 13.2 being corrosive in such a way that the chemical reaction 203 continues after the first electrode portion 13.1 is dissolved completely or essentially completely.

Figure 4 shows a diagram of a voltage characteristic in a further embodiment. Here, a curve of a voltage 103 is shown over a time t. Further, a predefined voltage range 100 is defined by a first voltage threshold 101 and a second voltage threshold 102. In case the voltage 103 exceeds (as shown) the second voltage threshold 102 or falls below the first voltage threshold 101, a critical voltage is assumed. Thus, a chemical reaction 203 can be processed by an indicator 10, e.g. as shown by one of the first three embodiments of figures 1 to 3.

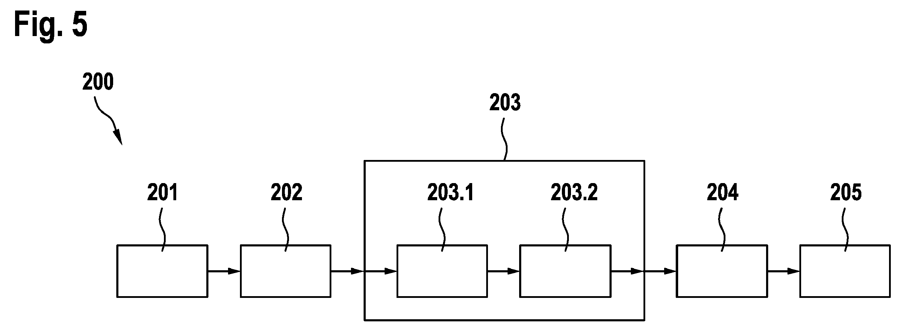

Figure 5 schematically shows a flow chart displaying a method 200 in a further embodiment according to the present invention. The method 200 can preferably start with a connecting 201 of at least a first and/or a second terminal 14.1, 14.2 of an indicator 10 to a device 1. Then, a voltage 103 is applied 202 to the indicator 10. Within the processing of a chemical reaction 203 a dissolving 203.1 of at least a part of a first electrode material of a first electrode portion 13.1 of a first electrode 13 of the indicator 10 can be included. Preferably, after the first electrode material is dissolved 203.1, the chemical reaction 203 can further include a dissolving 203.2 of at least a part of a second electrode material of a second electrode portion 13.2 of the first electrode 13. Then, in particular by and/or after returning to a predefined voltage range 100 by the voltage 103, a reverse reaction can be prevented 204, for example by a diode 15 which can be connected to the first electrode 13 as shown in the first embodiment of the indicator 10. Preferably, the method can further include a comparing 205 of a condition of the indicator 10 to a reference condition for proving the occurrence of overvoltage and/or undervoltage of the device 1 so as to receive an accurate result representing the proof of the occurrence of the critical voltage.

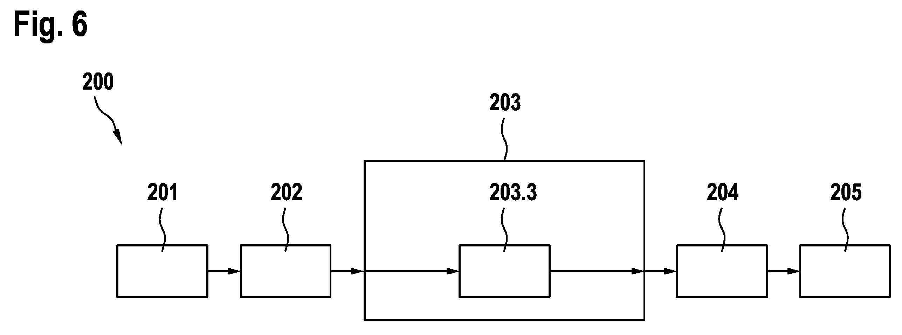

Figure 6 schematically shows a flow chart displaying a method 200 according to the present invention in a further embodiment, wherein the steps of the method 200 are the same as described for figure 5, except for the chemical reaction 203. Here, the chemical reaction 203 includes at least partly an accumulation 203.3 of the electrolyte 12 to the first electrode 13. Therefore, the electrode 13 does not dissolve, but it still reacts with the electrolyte 12 to provide the chemical reaction 203 and thus a proof of the occurrence of a critical voltage.

The methods described for figures 5 and 6 can in particular be realized with an indicator of one of the first four embodiments shown in figures 1 to 4.

The previous description of the embodiments describes the present invention only within the scope of examples. Naturally, also single features of the embodiments as far as technically meaningful can be freely combined with one another without leaving the scope of the present invention.

## Claims

1. An indicator (10) for proving an occurrence of a critical voltage in a device (1), in particular a battery module, comprising
a first electrode (13) connected to a first terminal (14.1),
and a second electrode (17) connected to a second terminal (14.2) for establishing an electrical connection (14) to the device (1),
and a reservoir (11) housing an electrolyte (12), wherein at least the first electrode (13) is at least partly immersed in the electrolyte (12),
wherein the electrolyte (12) and the first electrode (13) are configured in such a way that a chemical reaction (203) between the electrolyte (12) and the first electrode (13) is caused, when a voltage (103) of the electrical connection (14) differs from a predefined voltage range (100).

2. The indicator (10) according to claim 1,
**characterized in that**
the chemical reaction (203) is reversible.

3. The indicator (10) according to claim 1 or 2,
**characterized in that**
the at least one electrode (13, 17) is electrically connected to at least a first resistor (18), in particular so as to affect the voltage (103) and/or the predefined voltage range (100).

4. The indicator (10) according to any one of the preceding claims,
**characterized in that**
the first electrode (13) has a first portion (13.1) comprising a first electrode material and a second portion (13.2) comprising a second electrode material, wherein the first portion (13.1) at least partly covers the second portion (13.2), in particular wherein the second electrode material is more corrosive or less corrosive to the electrolyte (12) than the first electrode material.

5. The indicator (10) according to any one of the preceding claims,
**characterized in that**
a diode (15) is arranged between the first electrode (13) and the first terminal (14.1) and/or between the second electrode (17) and the second terminal (14.2).

6. A method (200) for proving an occurrence of a critical voltage of a device (1), in particular of a battery module, comprising the following steps:
a) Connecting (201) at least a first and/or a second terminal (14.1, 14.2) of an indicator (10), in particular according to any one of the preceding claims, to the device (1) and applying (202) a voltage (103) to the indicator (10),
b) Processing of a chemical reaction (203) between a first electrode (13) connected to the first terminal (14.1) and an electrolyte (12) housed in a reservoir (11) of the indicator (10), when a voltage (103) of the electrical connection (14) differs from a predefined voltage range (100), wherein a result of the chemical reaction (203) becomes recognizable.

7. The method (200) according to claim 6,
**characterized in that**
the chemical reaction (203) includes at least partly a dissolving (203.1) of a first electrode material of the first electrode (13) for entering a solution with the electrolyte (12).

8. The method (200) according to claim 7,
**characterized in that**
the chemical reaction (203) includes a dissolving (203.2) of at least a part of a second electrode material of a second electrode portion (13.2) of the first electrode (13) in the electrolyte (12), in particular after the complete or essentially complete dissolving of the first electrode material of the first electrode portion (13.1).

9. The method (200) according to any one of the preceding claims,
**characterized in that**
the chemical reaction (203) includes an accumulation (203.3) of at least a part of the electrolyte (12) by the first electrode (13).

10. The method (200) according to any one of the preceding claims,
**characterized in that**
the method further comprises the following step:
d) Preventing (204) a reverse reaction by at least one diode (15) which is connected in series with the first electrode (13) and the first terminal (14.1) and/or a second electrode (17), in particular which is at least partly immersed in the electrolyte (12), and the second terminal (14.2).
